(19) Europäisches Patentamt
European Patent Office
Office européen des brevets

(11) **EP 3 296 964 A1**

(12) **DEMANDE DE BREVET EUROPEEN**

(43) Date de publication:
**21.03.2018 Bulletin 2018/12**

(51) Int Cl.:
*G07C 5/08* (2006.01)          *G07C 5/00* (2006.01)
*B60W 50/02* (2012.01)          *F02N 11/00* (2006.01)

(21) Numéro de dépôt: **17190892.4**

(22) Date de dépôt: **13.09.2017**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**MA MD**

(30) Priorité: **13.09.2016 FR 1658545**

(71) Demandeur: **Valeo Systemes de Controle Moteur
95800 Cergy Saint Christophe (FR)**

(72) Inventeurs:
• KHELLAF, Yacine
  95800 Cergy Saint Christophe (FR)
• MARECHAL, Olivier
  80009 Amiens (FR)
• POTTEAU, Sébastien
  95800 Cergy Saint Christophe (FR)

(74) Mandataire: **Cardon, Nicolas**
**Valeo Systèmes de Contrôle Moteur
Immeuble Le Delta
14, avenue des Béguines
95800 Cergy St Christophe (FR)**

(54) **PROCÉDÉ D'ANALYSE DE DONNÉES DE COMPOSANTS DE VÉHICULES**

(57) L'invention concerne un procédé d'analyse de données de composants d'un véhicule comportant les étapes de : collecte des paramètres de conduite du véhicule, ces paramètres pouvant porter sur la vitesse de l'arbre moteur, le couple moteur, la vitesse des roues, la vitesse du véhicule, le kilométrage ; à partir de ces paramètres, évaluation d'une opération de démarrage ou de passage de vitesse en lui attribuant une note, estimation de l'état d'usure d'un embrayage, estimation d'au moins un état d'usure d'au moins un composant du véhicule ; transmission des informations relatives à l'état d'usure des composants et à la qualité d'une opération de démarrage ou de passage de vitesse à un objet connecté.

FIG.1

EP 3 296 964 A1

**Description**

DOMAINE

L'invention a trait au domaine de l'analyse et du suivi de données issus de composants d'un ou plusieurs véhicules routiers.

CONTEXTE

À partir des années 1980, l'électronique prend une place de plus en plus importante dans les véhicules, en particulier à travers l'utilisation d'un calculateur de contrôle moteur destiné à gérer le fonctionnement du moteur et à diagnostiquer ses défaillances.

Les diagnostics embarqués sont devenus progressivement de plus en plus sophistiqués, et permettent aux moteurs de ne pas dépasser les seuils d'émissions polluantes réglementaires.

L'OBD (On-Board Diagnostics en anglais) spécifie en particulier l'interface standard d'accès au système de diagnostics embarqués, et a été introduit dans le milieu des années 1990. L'OBD permet la lecture des Diagnostic Trouble Codes standardisés (ou DTC), générés par le système informatique embarqué, ainsi que les informations en provenance des capteurs connectés aux calculateurs de bord.

L'OBD se présente sous forme d'un boitier que l'utilisateur d'un véhicule peut brancher sur une prise prévue à cet effet sur son véhicule. Selon le modèle de boitier utilisé, le boitier est muni d'une interface sur laquelle s'affichent les données du calculateur du véhicule ou/et les données peuvent être récupérées via un câble USB, ou directement transmises par bluetooth ou wifi à un objet connecté comme par exemple un smartphone, une tablette ou un ordinateur.

L'interprétation de ces données n'est pas toujours aisée pour un utilisateur novice. En particulier, la présente invention propose d'analyser en temps réel (avec une durée d'exécution inférieure ou égale à quarante millisecondes), pendant la conduite du véhicule par l'utilisateur, les données du calculateur et de générer des conseils à l'utilisateur pour améliorer sa conduite.

Le problème de l'analyse de données à grande échelle se pose et génère de nouveaux avantages pour les personnels intéressés (constructeurs, équipementiers) et la sécurité des usagers de la route. En effet, il sera possible pour le constructeur de réaliser le suivi des différents composants sur le réseau routier ce qui rendra possible la détection précoce des défaillances. Par ailleurs, ces données sont utiles pour définir des profils de missions plus proches de la réalité terrain, lors de la réalisation de tests de validation sur des composants d'un véhicule.

La présente invention propose un procédé d'analyse de données de composants d'un véhicule comportant les étapes de :

- collecte en temps réel des paramètres de conduite du véhicule, pouvant porter sur : la vitesse de l'arbre moteur, le couple moteur, la vitesse du véhicule, le kilométrage,
- à partir de ces paramètres,

  ◦ évaluation d'une opération de décollage ou de passage de vitesses en lui attribuant une note,
  ◦ estimation d'au moins un état d'usure d'au moins un composant du véhicule, ledit état d'usure pouvant être un état d'usure atteint par le composant depuis le début de sa vie ou un état d'usure instantanée correspondant à une usure au cours d'une sollicitation.

- transmission des informations relatives à au moins un état d'usure des composants et à la qualité d'une opération de décollage ou de passage de vitesse à un objet connecté.

Les données collectées peuvent provenir d'un boitier OBD (On-Board Diagnostics), du bus CAN (Controller Area Network) du véhicule, ou de tout composant du véhicule équipé d'un module de connexion tel qu'une puce RFID.

Le composant analysé pour en déterminer un état d'usure peut être un embrayage, un démarreur, un alternateur ou tout autre composant du véhicule.

Selon un mode de réalisation, le procédé d'analyse de données de composants d'un véhicule comporte les étapes de :

- collecte en temps réel des paramètres de conduite du véhicule, pouvant porter sur : la vitesse de l'arbre moteur, le couple moteur, la vitesse du véhicule, le kilométrage,
- à partir de ces paramètres,

  ◦ évaluation de la qualité d'une opération de décollage ou de passage de vitesses en lui attribuant une note,

∘ estimation d'au moins un état d'usure d'au moins un composant du véhicule, ledit état d'usure pouvant être un état d'usure atteint par le composant depuis le début de sa vie ou un état d'usure instantanée correspondant à une usure au cours d'une sollicitation.

- transmission des informations relatives à au moins un état d'usure des composants et à la qualité d'une opération de décollage ou de passage de vitesse à un objet connecté.

Selon un mode de réalisation, l'évaluation de la qualité d'une opération comporte les étapes de :

- calcul de la durée de synchronisation entre la vitesse de l'arbre moteur du véhicule et la vitesse de l'arbre primaire de boîte de vitesses, la durée de synchronisation étant le temps écoulé entre le moment où la vitesse de l'arbre primaire de boîte de vitesses est nulle et le moment où cette vitesse est égale à celle de l'arbre moteur,
- attribution d'une note à l'opération en utilisant une table de correspondances entre notes et intervalles de durées de synchronisation.

L'évaluation de la qualité d'une opération de décollage ou de passage de vitesses, peut, selon un autre mode de réalisation possible, comporter les étapes de :

- calcul de l'énergie dissipée dans l'embrayage pendant la durée de l'opération,
- attribution d'une note à l'opération en utilisant une table de correspondances entre notes et valeurs d'énergie dissipée,

seules ou en complément des étapes du mode de réalisation précédent.
L'estimation de l'état d'usure atteint par un embrayage comporte les étapes de :

- calcul de l'énergie totale dissipée dans l'embrayage depuis le début de sa vie,
- comparaison de ces données à des données de références reliant directement un pourcentage d'usure et énergie totale dissipée.

L'estimation d'un état d'usure instantané de l'embrayage peut comprendre les étapes de:

- calcul de l'énergie dissipée sur un intervalle de temps prédéterminé,
- génération d'une alerte vers un objet connecté lorsque cette énergie dépasse une valeur prédéterminée.

Selon un mode de réalisation, l'estimation de l'état d'usure instantané de l'embrayage comporte des étapes de :

- calcul et suivi, sur une fenêtre de temps glissante défini par une durée prédéterminée, de l'énergie totale dissipée au cours de cette durée,
- génération d'un message d'alerte sur l'objet connecté lorsque cette énergie dépasse un seuil prédéfini.

Selon un deuxième mode de réalisation, l'estimation de l'état d'usure atteint par l'embrayage comprend des étapes de :

- calcul de l'écart entre la vitesse de l'arbre moteur et la vitesse de l'arbre primaire de boîte de vitesses,
- générer un signal d'alerte indiquant la présence d'un micro-patinage vers l'objet connecté lorsque cet écart appartient à un intervalle de valeurs prédéfini.

Selon un exemple de mode de réalisation, l'estimation de l'état d'usure atteint par le démarreur comporte des étapes de :

- calcul du nombre de démarrages du moteur depuis la première mise en circulation du véhicule,
- comparaison de ce nombre avec des données de références reliant le nombre de démarrages à un niveau d'usure du démarreur.

DESCRIPTION DETAILLEE

L'invention sera mieux comprise et d'autres détails, caractéristiques et avantages de l'invention apparaîtront à la lecture de la description suivante faite à titre d'exemple non limitatif en référence aux dessins annexés dans lesquels :

- la **FIG.1** est une illustration du réseau de communication global ;
- la **FIG.2** est une illustration du réseau de communication, centré sur un véhicule selon un exemple de mode de réalisation ;
- la **FIG.3** est une illustration du système d'analyse de données ;
- la **FIG.4** est un schéma simplifié du fonctionnement d'un système d'embrayage pour un exemple de véhicule ;
- La **FIG.5** illustre, pour un véhicule, l'évolution de la vitesse de l'arbre moteur et la vitesse de l'arbre primaire de boîte de vitesses au cours d'une phase de décollage ;
- La **FIG.6** illustre la distribution des conducteurs utilisant un même embrayage en fonction de la dissipation d'énergie dans l'embrayage pour un kilométrage donné.

Dans la présente description, est utilisée l'expression « état d'usure » pour désigner à la fois l'usure atteinte par un composant et l'usure instantanée liée à son utilisation au cours d'une sollicitation. Afin de distinguer ces deux cas, nous utiliserons respectivement les deux expressions « état d'usure atteint » pour le niveau d'usure atteint par un composant et « état d'usure instantané » pour l'usure instantanée du composant.

La présente invention est un système et un procédé d'analyse de données pouvant provenir de divers composants d'un ou plusieurs véhicules routiers. Les composants analysés peuvent être par exemple les embrayages, les amortisseurs, les alternateurs, les actionneurs de boîte de vitesses, un démarreur, etc.

Les objectifs de la présente invention sont :

- l'assistance à la conduite pour l'utilisateur (conducteur du véhicule),
- la détermination de profils de mission pour les tests de validation réalisés dans les ateliers des personnels intéressés (constructeurs, équipementiers),
- la détermination des états d'usure des différents composants des véhicules et des dates prévisionnelles de remplacement de ces composants.

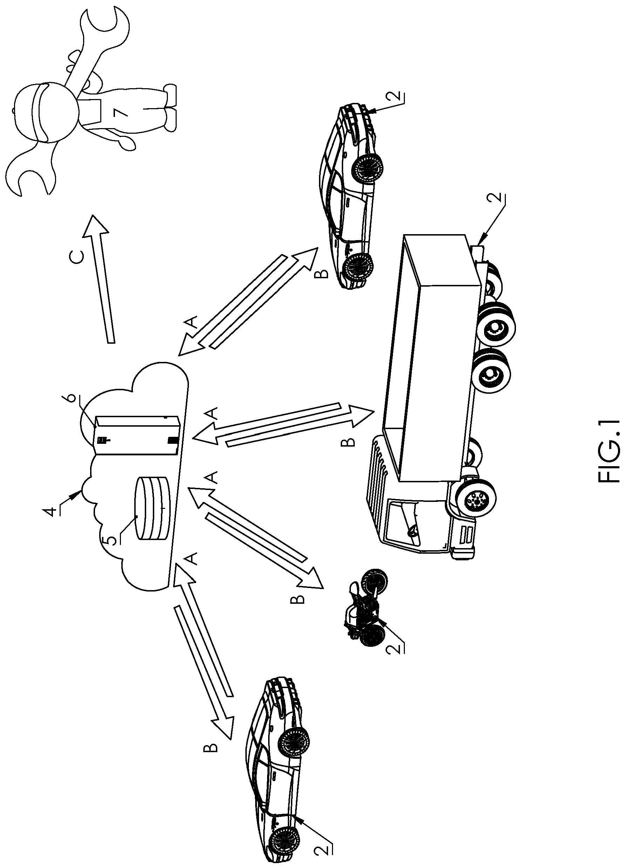

Nous nous référons à la **FIG.1** illustrant le réseau de communication global. Grâce à la transmission des informations via le boitier OBD **1** d'un véhicule **2** vers le smartphone **3** (ou tout autre objet connecté) du conducteur, les données brutes sont transmises (flèches **A**) au serveur **4** muni d'au moins une unité de stockage **5** et d'au moins un calculateur **6.** Les données brutes peuvent être analysées au niveau du serveur et retransmises en version « simplifiée » et adaptée au conducteur du véhicule afin de lui permettre de les assimiler rapidement et d'adapter sa conduite. Selon un autre mode de réalisation possible, l'objet connecté (smartphone, tablette, ordinateur) peut réaliser lui-même le traitement des données. Les personnels intéressés **7** (constructeurs, équipementiers, garagistes) peuvent avoir accès à ces données et solliciter via la même application que les utilisateurs des véhicules ou une autre application ou logiciel, une analyse des données concernant un composant particulier équipant un ou plusieurs véhicules **2** du réseau.

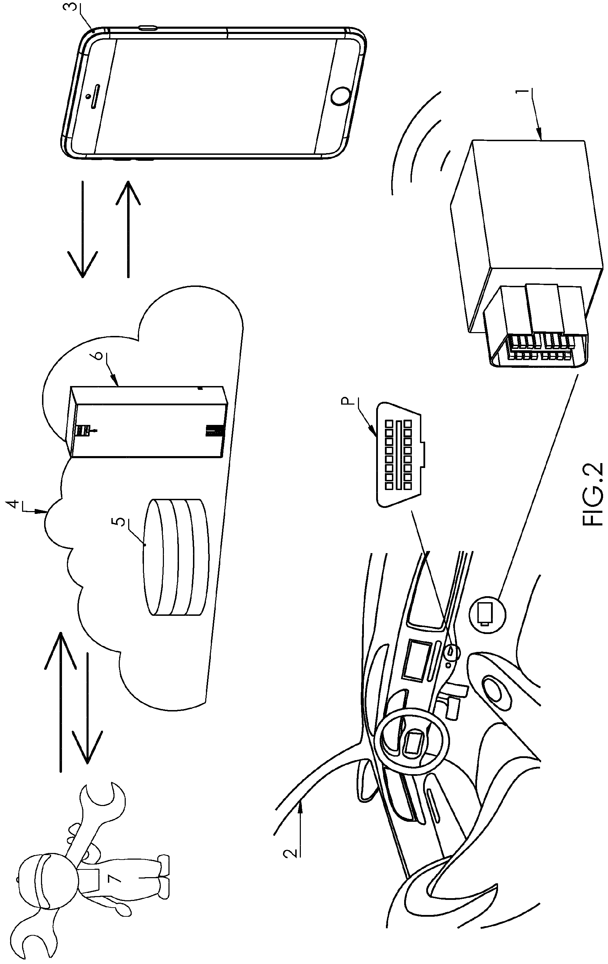

La **FIG.2** illustre dans le cas d'un véhicule **2**, comment se déroule la transmission des données depuis ce véhicule **2** vers le serveur **4**. Le boitier OBD est branché sur une prise **P** prévue à cet effet et localisée sur le tableau de bord du véhicule (elle peut être placée à proximité de l'allume cigare ou sous le volant). Celui-ci transmet les informations du calculateur du véhicule au smartphone **3** du conducteur par radiofréquence. Le smartphone **3** relaye les données brutes au serveur **4** (flèche **A**) pour que celles-ci soient analysées. Les données analysées sont ensuite transmises au conducteur (flèche **B**) et aux personnels intéressés (constructeurs, équipementiers). Selon l'exemple de mode de réalisation illustré dans la **FIG.2,** la collecte des données se fait via le boitier OBD **1.** Cependant les données peuvent, selon un autre mode de réalisation possible, provenir directement des composants du véhicule si les composants sont équipés d'un module de connexion (comme par exemple une puce RFID) capable de transmettre les informations à un autre objet connecté (smartphone, tablette, ordinateur, etc.). Les données peuvent, selon un autre mode de réalisation possible, provenir du bus CAN (Controller Area Network en anglais) du véhicule. Selon un autre mode de réalisation, les données peuvent provenir de plusieurs sources différentes (OBD, CAN, composants connectés du véhicule).

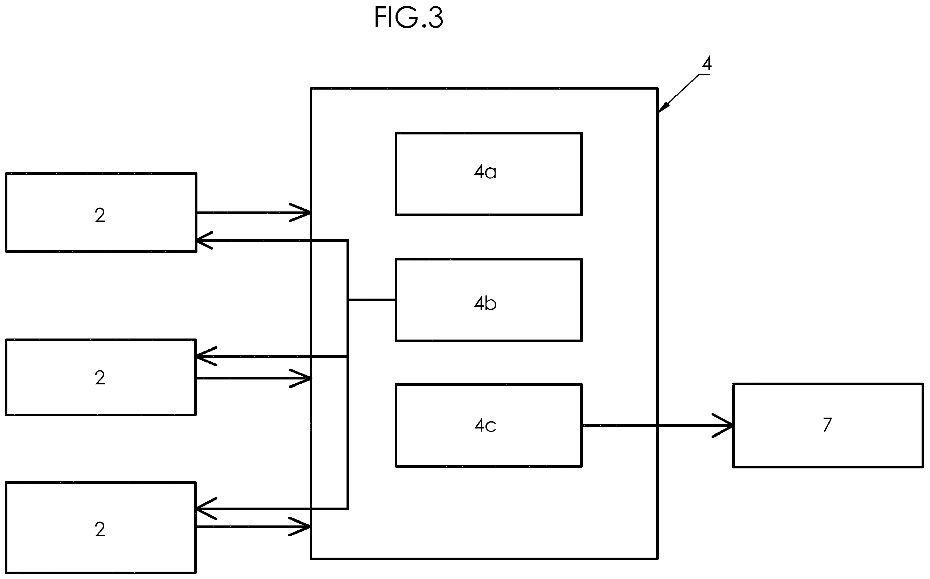

La **FIG.3** est une illustration du système d'analyse de données mise en oeuvre. Selon un exemple de mode de réalisation, il se compose de :

- un ou plusieurs véhicules **2** muni d'un OBD transmettant les informations du véhicule à un objet connecté,
- un serveur **4** muni de modules de stockage **4a,** d'assistance à la conduite **4b** et de maintenance **4c.**

Les données transmises au serveur **4** sont stockées dans une base de données grâce au module de stockage **4a.**

Le module d'assistance à la conduite **4b** permet de réaliser l'analyse des données à destination des conducteurs tandis que le module de maintenance **4c** permet de réaliser l'analyse de données à destination des personnels intéressés **7** (constructeurs, équipementiers).

Le module d'assistance à la conduite **4b** a pour objectifs :

- la détermination de l'influence de la conduite d'un utilisateur (utilisation de l'embrayage, passage des vitesses, freinage...) sur les différents composants d'un véhicule (embrayage, alternateur, démarreur etc.),
- la transmission au conducteur d'informations sur l'influence de sa conduite sur les différents composants du véhicule tels que l'embrayage, l'alternateur, le démarreur etc. et des recommandations pour améliorer sa conduite.

Dans ce document, les termes décollage et démarrage sont utilisés pour désigner deux opérations distinctes. Un démarrage est un actionnement du moteur du véhicule. Un décollage désigne une mise en mouvement du véhicule.
Pendant la conduite d'un véhicule, ce module **4b** réalise par exemple:

- l'analyse du décollage et du passage des vitesses,
- le comptage du nombre de démarrages réalisés par le conducteur,
- le calcul de l'énergie dissipée dans l'embrayage,
- l'estimation d'un état d'usure d'un composant, et en particulier du démarreur,
- la détection d'une situation où l'embrayage atteint un certain seuil de température.

Toutes ces données sont affichées sur l'interface du smartphone (ou autre objet connecté) de l'utilisateur.
Pour permettre au conducteur d'améliorer sa conduite, le module d'assistance à la conduite **4b** lui transmet également dans cet exemple:

- une note sur la qualité d'un décollage ou d'un passage de vitesse et un ou plusieurs conseils pour lui permettre d'améliorer sa conduite et son utilisation des différents composants du véhicule (par exemple, accélérer d'avantage ou passer la première vitesse) de façon à réduire la consommation de carburant, ou encore à diminuer l'énergie dissipée dans un des composants du véhicule, et ainsi retarder une opération de maintenance,
- un signal d'alerte dans le cas où un seuil de température a été détecté au niveau de l'embrayage.

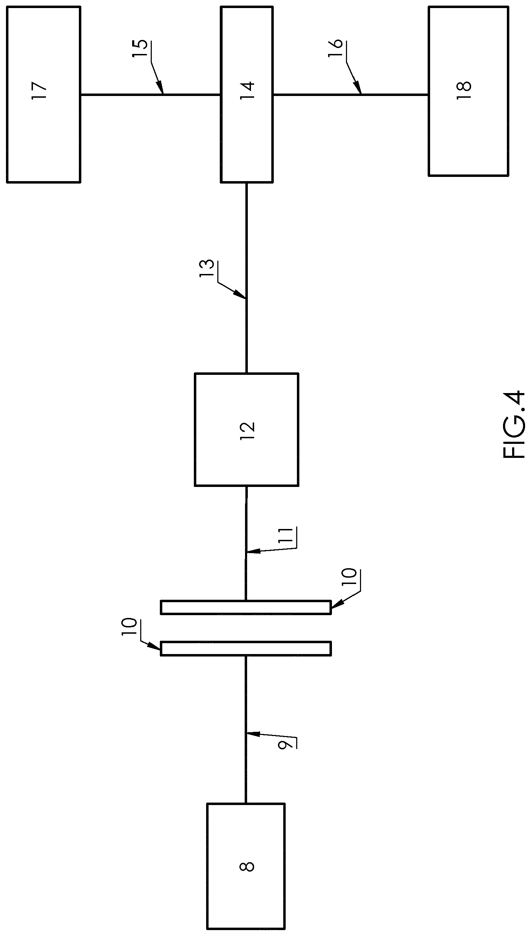

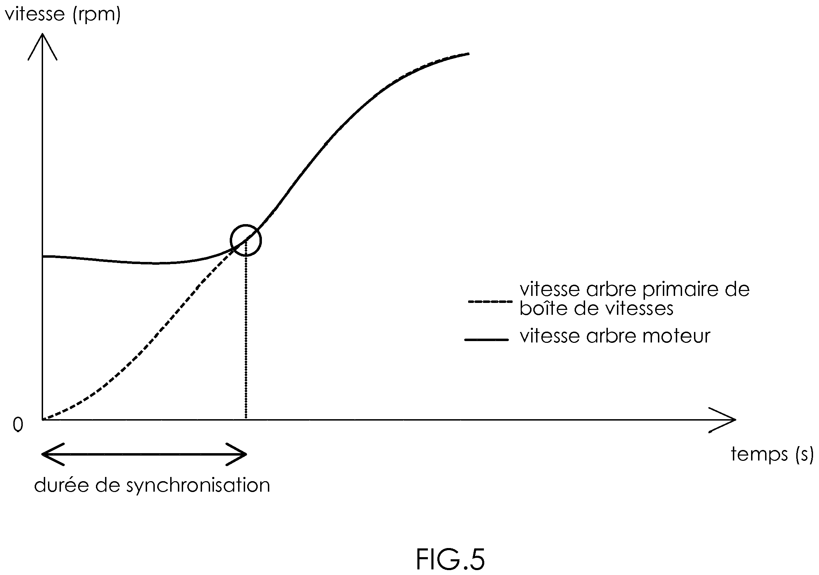

Nous nous référons maintenant à la **FIG.4** illustrant le fonctionnement d'un système d'embrayage de manière simplifiée. Ce système comprend un moteur **8**, un arbre moteur **9** dont la vitesse de rotation est notée $N_{moteur}$, un embrayage **10**, un arbre primaire de boîte de vitesses **11** dont la vitesse de rotation est notée $N_{bv1}$, une boîte de vitesses **12**, un arbre secondaire de boîte de vitesses **13** qui est aussi l'arbre d'entrée du différentiel dont la vitesse de rotation est notée $N_{bv2}$, un différentiel **14** contenant deux arbres de sortie **15** et **16** susceptibles d'entraîner les roues **17** et **18** en mouvement. La vitesse de rotation du moteur $N_{moteur}$, la vitesse linéaire du véhicule $v$, et la vitesse moyenne de rotation des roues $N_{roue}$ sont des données directement collectés par le système via le CAN et/ou l'OBD et/ou les composants du véhicules. Lorsque l'embrayage **10** est fermé, la vitesse de rotation de l'arbre primaire de boîte de vitesses $N_{bv1}$ est égale à celle de du moteur $N_{moteur}$. Sur la **FIG.5,** est représenté un exemple d'évolution des vitesses de l'arbre moteur et de l'arbre primaire de boîte de vitesses au cours d'une mise en mouvement du véhicule (décollage). La phase où l'embrayage **10** est fermé est indiqué par un cercle illustrant la position à laquelle on peut voir que les vitesses $N_{moteur}$ et $N_{bv1}$ sont égales. Lorsque l'embrayage est ouvert, la vitesse de rotation du moteur est connue mais celle de l'arbre primaire est déduite grâce au rapport du différentiel $R_{dif}$, au rapport de boîte de vitesses $R_{bv}$ et au rayon des roues $R_{roue}$, et à la vitesse $v$ du vélicule comme l'illustre l'équation (1) :

$$N_{bv1} = \frac{v}{R_{dif}R_{bv}R_{roues}} \qquad (1)$$

La grandeur $R_{dif}R_{bv}R_{roues}$ est obtenue en faisant le rapport entre la vitesse $v$ du véhicule et le régime moteur (vitesse de rotation du moteur) à la première vitesse (après le décollage du véhicule).
A partir de ces données, le système calcule la durée de synchronisation entre la vitesse de l'arbre moteur et la vitesse de l'arbre primaire de boîte de vitesses $N_{bv1}$ comme l'illustre la **FIG.4**. Cette durée de synchronisation correspond au temps, à couple non nul, pendant lequel la différence entre la vitesse de l'arbre moteur $N_{moteur}$ et la vitesse de l'arbre primaire de boîte de vitesses $N_{bv1}$ est proche de zéro, au micro-patinage près. Un micro-patinage correspond à une différence imperceptible entre la vitesse de rotation de l'arbre démarreur et la vitesse de rotation de l'arbre primaire de boîte de vitesse (généralement inférieure à cent rotations par minute).
Selon un exemple de mode de réalisation, une table de notation de la qualité d'un décollage ou d'un passage de vitesse associant des notes à plusieurs plages de durée de synchronisation est utilisée pour attribuer une note correspondant à la durée mesurée. Selon un autre mode de réalisation, cette table peut inclure des données relatives aux conditions climatiques et à la route (exemple de la présence d'un dénivelé) où toute autre information pouvant interférer sur le décollage d'un véhicule. Si c'est le cas, le système devra également collecter de telles informations sur le véhicule par exemple via les données de géolocalisation du véhicule.

Par ailleurs, selon un autre mode de réalisation possible, la notation de la qualité d'un décollage ou d'un passage de vitesse peut se faire en calculant l'énergie dissipée dans l'embrayage pendant une opération de décollage ou d'un passage de vitesse. Cette information peut être utilisée seule pour noter l'opération ou en complément de la durée de synchronisation entre les vitesses de l'arbre moteur et de l'arbre primaire de boîte de vitesses. La table utilisée dans ce cas inclut des données de correspondance entre l'énergie dissipée dans l'embrayage au cours de l'opération et la note.

Selon un autre mode de réalisation possible, la table peut aussi intégrer des valeurs dépendant des conditions d'utilisation telles que la présence de dénivelés sur la route, la masse totale du véhicule (remorque incluse si elle est présente). En effet, les dénivelés peuvent être évalués grâce à des accéléromètres présents sur le véhicules et / ou des données de géolocalisation. La masse du véhicule peut être déduite de l'accélération du véhicule et de la charge du moteur.

La note peut être un chiffre ou une couleur par exemple. Dans le cas de l'affichage de couleurs, on affichera par exemple la couleur verte pour une énergie dissipée strictement inférieure à trente kilojoules ($E_{dissipée} < 30kJ$), une couleur orange pour une énergie dissipée comprise entre trente et soixante kilojoules ($30 kj \leq E_{dissipée}(kJ) \leq 60 kJ$), et une couleur rouge pour une énergie dissipée strictement supérieure à soixante kilojoules ($E_{dissipée} > 60 kJ$). Si la note du décollage est qualifiée de mauvaise (exemple de la couleur rouge), alors un message écrit et / ou un message vocal indique au conducteur des instructions lui permettant d'améliorer son opération de décollage ou de passage de vitesse (par exemple « veuillez réduire le régime démarreur au moment du décollage »).

Grâce aux données de vitesses de rotation de l'arbre moteur et de l'arbre primaire de boîte de vitesses, ainsi qu'au couple moteur, le système réalise le calcul de l'énergie dissipée dans l'embrayage. L'estimation de l'état d'usure atteint par l'embrayage est fournie par la somme des énergies dissipées par l'embrayage au cours de sa vie.

Le calcul de l'énergie dissipée par un embrayage à un instant donnée est illustré par l'équation (2) :

$$E_{dissipée} = \int_0^{t_s} (N_{moteur} - N_{bv1})T\,dt \qquad (2)$$

où $E_{dissipée}$ est l'énergie dissipée dans l'embrayage, $N_{moteur}$ est la vitesse de rotation de l'arbre moteur, $N_{bv1}$ est la vitesse de rotation de l'arbre primaire de boîte de vitesses, et T est le couple moteur, $t_s$ est le temps de synchronisation entre la vitesse de l'arbre moteur et la vitesse de l'arbre primaire de boîte de vitesses. Ce calcul illustre l'estimation d'un état d'usure instantané lié à une sollicitation de l'embrayage pendant une durée $t_s$.

Le couple T peut être obtenu via le CAN du véhicule, mais celui-ci peut également être estimé à partir de l'accélération du véhicule et sa masse, ou encore à partir de la charge de l'accélérateur.

Par ailleurs, il est possible d'accéder à l'historique de l'énergie dissipée par un embrayage depuis sa première utilisation. Si cet historique n'est pas disponible, le système recherche, parmi les véhicules présents dans le réseau et équipés du même modèle d'embrayage, les données relatives à leur embrayage et reconstitue une moyenne statistique de l'énergie dissipée au cours de sa vie. Il est connu d'estimer l'état d'usure atteint par un embrayage en fonction de l'énergie qu'il a dissipé au cours de sa vie.

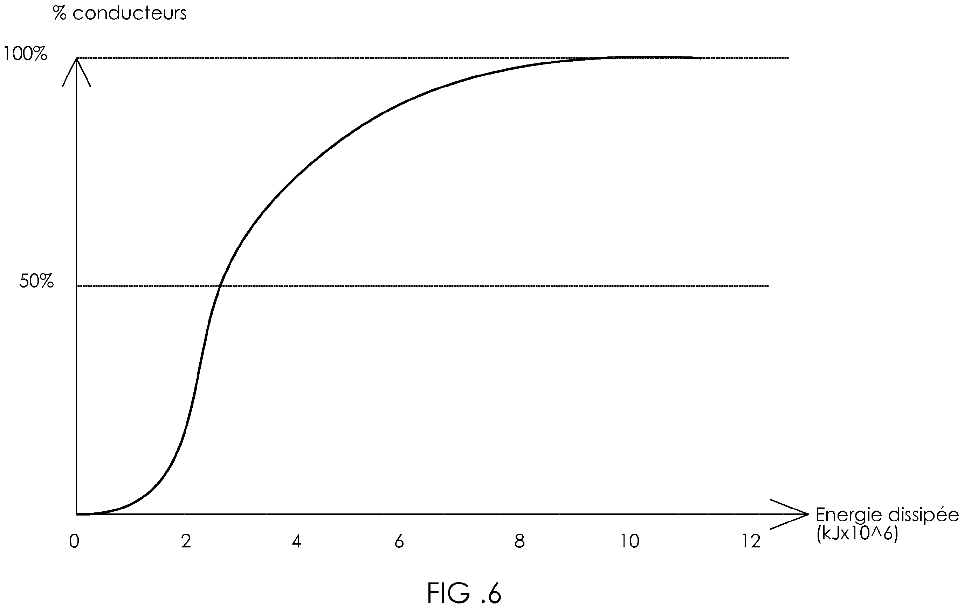

La **FIG.6** illustre la distribution des conducteurs utilisant un même embrayage en fonction de la dissipation d'énergie pour un kilométrage donné. Dans le cas de la **FIG.6**, 50% des conducteurs ont dissipé $2,5.10^6$ kilojoules. Afin de déterminer la moyenne d'énergie dissipée par un conducteur, le système détermine le profil de sévérité du conducteur, ce profil étant défini par un pourcentage qualifiant son utilisation de l'embrayage. A partir de ce profil, on peut alors reconstituer l'énergie moyenne qui a déjà été dissipée au cours de la durée de vie de l'embrayage grâce au modèle correspondant au kilométrage du véhicule concerné, et la garde d'usure restante.

Si l'énergie dissipée par l'embrayage s'écarte des recommandations de niveau d'usure fournies par les constructeurs, le système génère à l'utilisateur des instructions d'amélioration de sa conduite pour diminuer cette énergie dissipée. L'énergie dissipée peut être élevée dans le cas où le conducteur maintient la pédale d'embrayage trop longtemps au niveau du point de patinage. Dans ce cas, une recommandation du type « diminuer le temps de maintien du point de patinage » pourrait être envoyée à l'utilisateur.

Pendant l'utilisation du véhicule, le système calcule le nombre de démarrages réalisés. Cela permet de suivre le nombre de démarrages d'un véhicule tout au long de sa vie. Cette donnée est enregistrée dans la base de données du réseau et mise à jour à chaque utilisation du véhicule. Le système incrémente le nombre de démarrages effectués par un véhicule à chaque fois que la vitesse de l'arbre moteur passe d'une vitesse strictement inférieure à cinq cent rotations par minute à une vitesse supérieure ou égale à cinq cent rotations par minute. Les données du constructeur fournissent également des courbes caractéristiques permettant de déterminer l'état d'usure atteint par un démarreur en fonction du nombre de démarrages qu'il a effectués au cours de sa vie. Par exemple, pour un véhicule de type « segment B », le démarreur peut réaliser jusqu'à cinquante mille démarrages au cours de sa vie. Au-delà, il devra être changé.

Par ailleurs, le système vérifie la température de l'embrayage pendant l'utilisation du véhicule en détectant une éventuelle surchauffe. Pour détecter une surchauffe le système calcule, à un instant quelconque noté t, l'énergie totale dissipée dans l'embrayage pendant un intervalle de temps antérieur à l'instant t et s'achevant à l'instant t. Selon un mode préféré de réalisation, cet intervalle de temps est de dix minutes. Lorsque la valeur de l'énergie dissipée pendant cet intervalle de temps est supérieure ou égale à un certain seuil, une alerte est envoyée au conducteur. Selon un mode préféré de réalisation ce seuil est compris entre quatre cent et six cent kilojoules.

Les véhicules connectés au réseau génèrent des données utiles pour les personnels concernés (constructeurs, équipementiers). Il devient possible pour les personnels intéressés d'accéder à des données concernant un composant d'intérêt. Par exemple, si des équipementiers souhaitent avoir des informations sur un embrayage particulier, il leur est possible de collecter des informations de tous les embrayages du même type dans le réseau. Les informations contenues dans la base de données du réseau sont notamment les suivantes :

- les profils des conducteurs concernés et les numéros de compte d'application correspondant,
- pour chaque numéro de compte:

  ◦ le pays et le type de route emprunté (ville, autoroute, campagne) via des données de géolocalisation,
  ◦ les conditions climatiques,
  ◦ le nombre d'opérations au kilomètre, une opération correspondant à un passage de vitesse ou à un décollage,
  ◦ le nombre de démarrages du véhicule,
  ◦ le cumul de l'énergie dissipée dans l'embrayage, ce cumul correspondant à la somme des énergies dissipées par l'embrayage au cours de sa vie,
  ◦ le temps passé en pleine charge.

A partir des données de tous les véhicules, le système sélectionne les données des véhicules du réseau qui sont équipés du composant à analyser, et reconstruit à partir de ces données, une représentation des données utilisables et facilement interprétables par les personnels intéressés. Les données sont analysées, par le module de maintenance **4c**, de manière à dresser, pour un composant d'intérêt, la répartition de la sollicitation des conducteurs en fonction de paramètres d'intérêt qui peuvent être choisis par les personnels intéressés. Par exemple dans le cas d'un embrayage, un équipementier peut avoir un intérêt à obtenir une répartition de la sollicitation des conducteurs en fonction :

- du nombre d'opérations au kilomètre pour chaque type de route (ville, route, autoroute), chaque secteur géographique (Europe, Asie, Inde), et chaque type de véhicule (citadine, routière, essence, diesel etc),
- du temps passé en pleine charge,
- du nombre de démarrages du véhicule pour chaque profil routier, chaque secteur géographique, et chaque type de véhicule (citadine, routière, essence, diesel etc.),
- de l'énergie dissipée pour chaque profil routier, chaque secteur géographique, et chaque type de véhicule (citadine, routière, essence, diesel etc).

Les répartitions sont ensuite regroupées pour dresser des profils d'utilisation correspondant respectivement à 50%, 90% et 99% des utilisateurs.

Ces données sont utiles pour les équipementiers car elles peuvent leur permettre de compléter et d'enrichir des profils de mission de tests de leurs composants. Par ailleurs ces informations peuvent être utiles pour le dimensionnement de ces composants. En effet, ces éléments peuvent permettre de dimensionner des composants d'un embrayage tels que un diaphragme (grâce au nombre d'opération au kilomètre), des ressorts et des systèmes d'hystérésis (grâce au temps passé en pleine charge). La répartition des conducteurs en fonction du nombre de démarrages du véhicule et de l'énergie dissipée, pour chaque profil routier permet de dimensionner la réserve d'usure de l'embrayage.

Ce dernier élément permet également aux personnels concernés d'obtenir, via le module de maintenance **4c**, une estimation en temps réel d'un état d'usure de l'embrayage et / ou de détecter les premiers signes de faiblesse de l'embrayage. Un premier signe de faiblesse correspond notamment à un début de patinage anormal. Lorsque l'embrayage est fermé (arbre démarreur solidaire de l'arbre primaire de boîte de vitesses), l'arbre moteur et l'arbre primaire de boîte de vitesses doivent avoir la même vitesse de rotation. En suivant leurs vitesses respectives, le système peut détecter des micro-patinages qui ne sont pas perceptibles par le conducteur. Un micro-patinage est généralement imperceptible par un conducteur lorsqu'il est inférieur ou égal à cent rotations par minute. Lorsque le système détecte un micro-patinage supérieur à un seuil qui est un paramètre, celui-ci enregistre l'information dans la base de données. Selon un mode préféré de réalisation, le seuil de détection d'un micro-patinage est compris entre vingt et deux cent rotations par minutes. La détection des micro-patinages et l'estimation de l'état d'usure atteint par l'embrayage, réalisés grâce au calcul de l'énergie dissipée sont des données complémentaires qui permettent aux personnels intéressés de prédire l'usure totale de l'embrayage.

Ces informations sont alors transmises directement aux personnels intéressés (usines, service après-vente) pour anticiper des volumes de rechange, et les besoins du consommateur.

L'invention n'est pas limitée à ce qui vient d'être décrit.

**Revendications**

1. Procédé d'analyse de données de composants d'un véhicule comportant des étapes de :

   - collecte des paramètres de conduite du véhicule **(2),** pouvant porter sur : la vitesse de l'arbre moteur, le couple moteur, la vitesse des roues, le kilométrage, la vitesse du véhicule,
   - à partir de ces paramètres,

     ◦ évaluation de la qualité d'une opération de décollage ou de passage de vitesse en lui attribuant une note,
     ◦ estimation d'au moins un état d'usure d'au moins un composant, ledit état d'usure pouvant être un état d'usure atteint par le composant depuis le début de sa vie ou un état d'usure instantanée correspondant à une usure au cours d'une sollicitation,

   - transmission des informations relatives à au moins un état d'usure d'au moins un composant et à la qualité d'une opération de décollage ou de passage de vitesse à un objet connecté **(3).**

2. Procédé selon la revendication 1, **caractérisé en ce que** les données collectées peuvent provenir d'un boitier OBD **(1)** (On-Board Diagnostics), du bus CAN (Controller Area Network) du véhicule **(2),** ou de tout composant du véhicule **(2)** équipé d'un module de connexion tel qu'une puce RFID.

3. Procédé selon l'une quelconque des revendications 1 et 2, **caractérisé en ce que** le composant analysé pour en déterminer un état d'usure, est un démarreur, un embrayage, un alternateur, ou un moteur.

4. Procédé selon l'une quelconque des revendications 1 à 3, **caractérisée en ce que** l'évaluation de la qualité d'une opération de décollage ou de passage de vitesse comporte des étapes de :

   - calcul de la durée de synchronisation entre la vitesse de l'arbre moteur du véhicule et la vitesse de l'arbre primaire de boîte de vitesses, la durée de synchronisation étant le temps écoulé entre le moment où la vitesse de l'arbre primaire de boîte de vitesses est nulle et le moment où cette vitesse est égale à celle de l'arbre moteur,
   - attribution d'une note à l'opération en utilisant une table de correspondances entre notes et intervalles de durées de synchronisation.

5. Procédé selon l'une quelconque des revendications 1 à 4, **caractérisé en ce que** l'évaluation de la qualité d'une opération de décollage ou de passage de vitesse comporte des étapes de :

   - calcul de l'énergie dissipée dans l'embrayage pendant la durée de l'opération,
   - attribution d'une note à l'opération en utilisant une table de correspondances entre notes et valeurs d'énergie dissipée.

6. Procédé selon l'une quelconque des revendications 1 à 5, **caractérisé en ce que** l'estimation de l'état d'usure atteint par un embrayage comporte des étapes de :

   - calcul de l'énergie totale dissipée dans l'embrayage depuis le début de sa vie,
   - comparaison de ces données à des données de références reliant des valeurs de pourcentage d'usure et à des valeurs d'énergie totale dissipée.

7. Procédé selon l'une quelconque des revendications 1 à 6, **caractérisé en ce que** l'estimation de l'état d'usure instantanée de l'embrayage comprend les étapes de :

   - calcul de l'énergie dissipée sur un intervalle de temps prédéterminé,
   - génération d'une alerte d'usure vers un objet connecté lorsque cette énergie dépasse une valeur prédéterminée.

8. Procédé selon l'une quelconque des revendications 1 à 6, **caractérisé en ce que** l'estimation d'un état d'usure instantané de l'embrayage comporte des étapes de :

- calcul et suivi, sur une fenêtre de temps glissante définie par une durée prédéterminée, de l'énergie totale dissipée au cours de cette durée,
- génération d'un message d'alerte sur l'objet connecté lorsque cette énergie totale dissipée dépasse un seuil prédéfini.

9. Procédé selon l'une quelconque des revendications 1 à 6, **caractérisé en ce que** l'estimation d'un état d'usure instantané de l'embrayage comprend des étapes de :

- calcul de l'écart entre la vitesse de l'arbre moteur et la vitesse de l'arbre primaire de boîte de vitesse,
- génération d'un signal d'alerte indiquant la présence d'un micro-patinage vers l'objet connecté lorsque cet écart appartient à un intervalle de valeurs prédéfini.

10. Procédé selon l'une quelconque des revendications 1 à 9, **caractérisée en ce que** l'estimation de l'état d'usure atteint par le démarreur comporte des étapes de :

- calcul du nombre de démarrages du moteur depuis la mise en circulation du véhicule **(2),**
- comparaison de ce nombre avec des données de références reliant nombre de démarrages et niveau d'usure du démarreur.

FIG.1

EP 3 296 964 A1

FIG.2

EP 3 296 964 A1

FIG.3

FIG.4

vitesse (rpm)

— — — vitesse arbre primaire de
boîte de vitesses

——— vitesse arbre moteur

0

temps (s)

durée de synchronisation

FIG.5

EP 3 296 964 A1

FIG .6

**Europäisches Patentamt**

**European Patent Office**

**Office européen des brevets**

# RAPPORT DE RECHERCHE EUROPEENNE

Numéro de la demande

EP 17 19 0892

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | FR 2 814 841 A1 (RENAULT [FR]) 5 avril 2002 (2002-04-05) | 1-3 | INV. G07C5/08 |
| Y | * revendications 1,2,6-8 * * figure 2 * * page 6, ligne 18 - page 7, ligne 9 * ----- | 4-10 | ADD. G07C5/00 B60W50/02 F02N11/00 |
| Y | EP 2 767 817 A1 (IVECO SPA [IT]) 20 août 2014 (2014-08-20) * revendication 1 * * alinéa [0018] * * alinéa [0022] - alinéa [0025] * * alinéa [0037] * ----- | 4-9 | |
| Y | US 2004/061603 A1 (MACK WILLIAM J [US]) 1 avril 2004 (2004-04-01) * alinéa [0005] * * alinéa [0013] * * alinéa [0029] * ----- | 4-9 | |
| Y | US 6 748 305 B1 (KLAUSNER MARKUS [US] ET AL) 8 juin 2004 (2004-06-08) * colonne 10, ligne 52 - ligne 56 * ----- | 10 | |

| DOMAINES TECHNIQUES RECHERCHES (IPC) |
|---|
| G07C G06F B60W F02N F16D |

Le présent rapport a été établi pour toutes les revendications

| Lieu de la recherche | Date d'achèvement de la recherche | Examinateur |
|---|---|---|
| La Haye | 2 février 2018 | Hniene, Badr |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 17 19 0892

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-02-2018

| Document brevet cité au rapport de recherche | | Date de publication | Membre(s) de la famille de brevet(s) | | Date de publication |
|---|---|---|---|---|---|
| FR 2814841 | A1 | 05-04-2002 | AUCUN | | |
| EP 2767817 | A1 | 20-08-2014 | AUCUN | | |
| US 2004061603 | A1 | 01-04-2004 | AU | 2003263541 A1 | 23-04-2004 |
| | | | BR | 0314508 A | 26-07-2005 |
| | | | CN | 1695013 A | 09-11-2005 |
| | | | DE | 60320120 T2 | 18-06-2009 |
| | | | EP | 1546570 A1 | 29-06-2005 |
| | | | JP | 4702595 B2 | 15-06-2011 |
| | | | JP | 2006501420 A | 12-01-2006 |
| | | | US | 2004061603 A1 | 01-04-2004 |
| | | | WO | 2004031604 A1 | 15-04-2004 |
| US 6748305 | B1 | 08-06-2004 | DE | 10014994 A1 | 05-10-2000 |
| | | | EP | 1169686 A1 | 09-01-2002 |
| | | | US | 6748305 B1 | 08-06-2004 |
| | | | WO | 0060547 A1 | 12-10-2000 |

EPO FORM P0460

Pour tout renseignement concernant cette annexe : voir Journal Officiel de l'Office européen des brevets, No.12/82